(19) **Europäisches Patentamt / European Patent Office / Office européen des brevets**

(11) **EP 2 056 504 B1**

(12) **EUROPEAN PATENT SPECIFICATION**

(45) Date of publication and mention
of the grant of the patent:
**20.02.2013   Bulletin 2013/08**

(51) Int Cl.:
*H04J 13/00* *(2011.01)*

(21) Application number: **07817173.3**

(22) Date of filing: **30.10.2007**

(86) International application number:
**PCT/CN2007/070982**

(87) International publication number:
**WO 2008/052477 (08.05.2008 Gazette 2008/19)**

(54) **A CODE MULTIPLEXING METHOD AND SYSTEM FOR HIGH SPEED DOWNLINK SHARED CHANNEL**

KODEMULTIPLEX-VERFAHREN UND -SYSTEM FÜR EINEN GEMEINSAMEN BENUTZTEN SCHNELLEN ABWÄRTSSTRECKENKANAL

PROCÉDÉ DE MULTIPLEXAGE DE CODE ET SYSTÈME DE CANAL PARTAGÉ DE LIAISON DESCENDANTE HAUTE VITESSE

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **31.10.2006   CN 200610143885**
**04.04.2007   CN 200710088882**

(43) Date of publication of application:
**06.05.2009   Bulletin 2009/19**

(60) Divisional application:
**10153140.8 / 2 190 140**
**12199595.5**

(73) Proprietor: **Huawei Technologies Co., Ltd.**
**Longgang District, Shenzhen**
**Guangdong 518129 (CN)**

(72) Inventors:
• **YU, Rongdao**
  **Shenzhen**
  **Guangdong 518129 (CN)**
• **LIU, Sheng**
  **Shenzhen**
  **Guangdong 518129 (CN)**
• **LI, Qi**
  **Shenzhen**
  **Guangdong 518129 (CN)**

(74) Representative: **Pfenning, Meinig & Partner GbR**
**Theresienhöhe 13**
**80339 München (DE)**

(56) References cited:
**WO-A1-02/43297      WO-A1-2006/117268**
**CN-A- 1 633 052      CN-A- 1 700 624**
**CN-A- 1 893 342**

• **"3GPP TR 25.858 V5.0.0; Technical Specification Group Radio Access Network; High Speed Downlink Packet Access: Physical Layer Aspects (Release 5)" 3RD GENERATION PARTNERSHIP PROJECT, [Online] 29 March 2002 (2002-03-29), pages 1-31, XP002549338 Retrieved from the Internet: URL:http://www.3gpp.org/ftp/Specs/ archive/ 25_series/25.858/25858-500.zip> [retrieved on 2009-09-30]**
• **PANASONIC: "Enhanced HARQ Method with Signal Constellation Rearrangement" TSG-RAN WORKING GROUP 1 MEETING #19, TSGR1#19 (01)0237, [Online] 27 February 2001 (2001-02-27), - 2 March 2001 (2001-03-02) pages 1-11, XP002549339 Las Vegas, USA Retrieved from the Internet: URL:http://isearch.etsi.org/ 3GPPSearch/isy squery/119b8d95-f287-4552-b3d8-884506ce1ae 4/5/doc/> [retrieved on 2009-09-30]**

## Description

This application claims priorities of Chinese Patent Application No. 200610143885.6 filed on October 31, 2006, entitled as "Method and System for Coding and Multiplexing In High Speed Downlink Shared Channel" and Chinese Patent Application No. 200710088882.1 filed on April 4, 2007, entitled as "Method and System for Coding and Multiplexing In High Speed Downlink Shared Channel".

Field of the Invention

The present invention relates to the field of wireless communication, and particularly to the technology of coding and multiplexing in high speed downlink shared channel.

Background of the Invention

As an enhanced downlink wireless transmission technology, High Speed Downlink Packet Access (HSDPA) has distinct advantages of high spectral efficiency, high downlink transmission speed and short transmission delay, it is able to support packet data traffic effectively, because the technology employs some key technologies such as link adaptation technology based on the adaptive modulation and coding, Hybrid Automatic Repeat Request (HARQ) based on the physical layer retransmission and soft combining, multi-user fast packet scheduling, 2ms short frame.

Enhanced Dedicated Channel (E-DCH), also referred to as High Speed Uplink Packet Access (HSUPA), has advantages of high spectral efficiency, high uplink transmission speed and short transmission delay and thereby supports packet data traffic applications such as real-time games, file upload, broadband multimedia and so on due to using some key technologies, for example, uplink fast packet scheduling based on Node Base Station (Node B), fast HARQ and 2ms short frame.

The HSDPA/HSUPA technology based on Code Division Multiple Access (CDMA) has been more and more difficult to meet the increasingly developing demands on broader transmission bandwidth (for example, 20MHz) and higher transmission speed (for example, 100~200Mbps) of the mobile communication due to the limitation of the inherent multi-path interference in the CDMA system. At the same time, the Orthogonal Frequency Division Multiplexing (OFDM) technology is gradually becoming a major multiple access approach used by the future wireless communication system because compared with CDMA, it has better anti multi-path capability and a relatively simple receiver, and it is easier to combine with the multi-antenna technology.

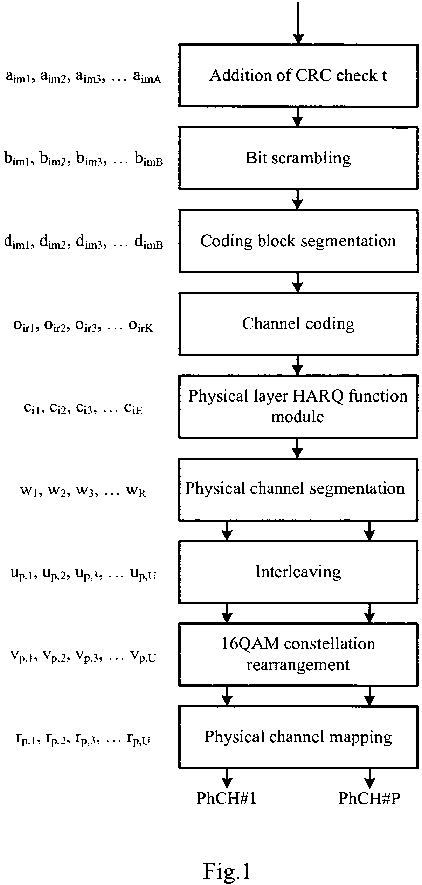

Figure 1 shows the HS-DSCH coding and multiplexing. The 2m Transmission Timing Interval (TTI) of the High Speed Downlink Shared Channel (HS-DSCH) bears at most one data block, and each HS-DSCH data block for inputting coding and multiplexing chain is mapped into a 3-slot HS-DSCH sub-frame after being coded and multiplexed. The HS-DSCH coding and multiplexing procedure mainly includes the following steps: addition of Cyclic Redundancy Check (CRC) information in transport block, bit scrambling, coding block segmentation, channel coding, HARQ, physical channel segmentation, interleaving, 16 Quadrature Amplitude Modulation (QAM) constellation rearrangement and physical channel mapping. These steps will be described one by one below.

Addition of CRC information:

The CRC carries out error check for the transport block in the current TTI frame of transmission channel. The HS-DSCH check has a length of 24 bits. CRC calculations are performed for the transport block bit by bit, and CRC check bits are generated according to the cyclic generation polynomial gCRC24(D) = D24 + D23 + D6 + D5 + D + 1.

Bit scrambling:

Assuming that the input bits input to the bit scrambling module are $b_{im,1}$ ,$b_{im,2}$ ,$b_{im,3}$ ,...,$b_{im,B}$, where B is the number of bits input to the bit scrambling module, and the scrambled bits are represented as: $d_{im,1}$, $d_{im,2}$, $d_{im,3}$,...,$d_{im,B}$. Then the bit scrambling is defined as the following relationship:

$$d_{im,k} = \left(b_{im,k} + y_k\right) \bmod 2, \qquad k = 1,2,...,B$$

where, $y_k$ is calculated as follows:

$$y'_\gamma = 0 \quad -15 < \gamma < 1$$

$$y'_\gamma = 1 \qquad \gamma = 1$$

$$y'_\gamma = \left( \sum_{x=1}^{16} g_x \cdot y'_{\gamma-x} \right) \bmod 2 \qquad 1 < \gamma \leq B,$$

where, g = {$g_1, g_2, ..., g_{16}$] = {0,0,0,0,0,0,0,0,0,0,1,0,1,1,0,1},

$$y_k = y'_k \quad k = 1, 2, ..., B.$$

Coding block segmentation:

The coding block segmentation method for the HS-DSCH is the same as that for the other transmission channels, but has the following limitation: the maximum number of the coding blocks i = 1, the input module of the coding block segmentation module $d_{im1}$, $d_{im2}$, $d_{im3}$,...$d_{imB}$ is directly mapped to $x_{i1}$, $x_{i2}$, $x_{i3}$,...$x_{iXi}$, and X1 = B, where, x only represents the internal module of the coding and multiplexing chain.

Channel coding:

The channel coding method for the HS-DSCH is the same as that for the other transmission channels, but has the following limitations: the maximum number of the transport blocks i = I and 1/3-rate Turbo code is used.

HARQ of the HS-DSCH

The HARQ makes the number of bits output from the channel coding module equal to the total number of bits distributed by the physical channel to the HS-DSCH, the function of which is similar to the rate matching module in the coding and multiplexing chain of the other transmission channels. Redundancy Version (VR) controls the operations of the HARQ. The number of output bits of the HARQ module is determined by the number of input bits, number of output bits and RV parameters.

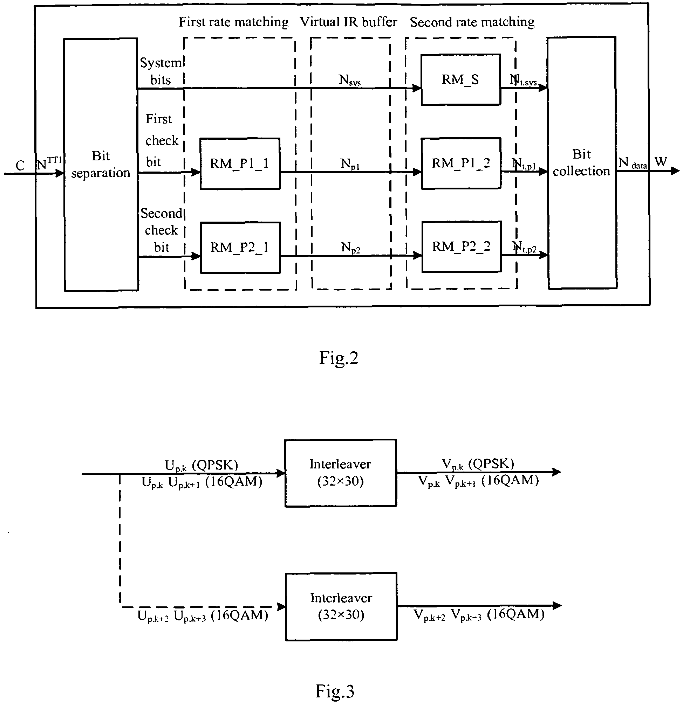

As shown in Figure 2, the HARQ is composed of two levels of rate matching and one buffer. The first rate matching sub-module matches the input to the number of bit of virtual IR buffer, and parameters of this rate matching sub-module are given by the upper layer. The first rate matching is transparent if the number of input bits does not exceed the capacity of the virtual IR buffer. The second rate matching unit matches the number of HS-DSCH TTI bits output from the first rate matching to the number of HS-PDSCH bits in a physical channel frame.

The HARQ bit separating module has the function of separating a system bit sequence, a first check bit sequence and a second check bit sequence from the input bit sequence.

The function of the first rate matching module of the HARQ is as follows: the upper layer configures the maximum number of soft bits $N_{IR}$ of the virtual IR buffer for each HARQ processing, and the number of input bits of the first rate matching module is $N^{TTI}$. If $N_{IR}$ is larger than or equal to $N^{TTI}$, i.e. all of the coding information bits of the TTI frame may be stored, the first rate matching sub-module is transparent. If $N_{IR}$ is less than $N^{TTI}$, puncturing is implemented,

$$\Delta N_{il}^{TTI} = N_{IR} - N^{TTI} .$$

The function of the second rate matching sub-module of the HARQ is as follows: RV parameters of s and r control parameters of the second rate matching algorithm. The value of the parameter s is 0 or 1, which corresponds to a priority bit (s=1) and non-priority bit (s=0) respectively. The parameter r (which is ranged from 0 to $r_{max}$) controls the initial error parameter $e_{ini}$ when the puncturing is implemented. In the case of bit repetition, both parameter r and s may control the initial error parameter $e_{ini}$. The calculations of the parameters X, $e_{plus}$ and $e_{minus}$ are shown in Table 2. The number of system bits of the second rate matching is $N_{sys}$. The first check bit is $N_{p1}$, the second check bit is $N_{p2}$, the number of physical channels bearing CCTrCH is P, and the number of CCTrCH data bit in the physical channel frame is $N_{data}$, and $N_{data} = P \times 3 \times N_{data1}$.

Table 2 The second rate matching parameter s of HARQ

|  | $X_i$ | $e_{plus}$ | $e_{minus}$ |
|---|---|---|---|
| System sequence RM S | $N_{sys}$ | $N_{sys}$ | $|N_{sys} - N_{t,sys}|$ |
| First check sequence RM P1_2 | $N_{p1}$ | $2 \cdot N_{p1}$ | $2 \cdot |N_{p1} - N_{t,p1}|$ |
| Second check sequence RM P2_2 | $N_{p2}$ | $N_{p2}$ | $|N_{p2} - N_{t,p2}|$ |

If $N_{data} <= N_{sys} + N_{p1} + N_{p2}$, the second rate matching sub-module implements punching operation. The number of transmitted priority system bits is $N_{t,sys} = \min(N_{Nsys}, N_{data})$, and the number of transmitted non-priority system bits is

$N_{t,sys}= \max\{N_{data} - (N_{p1}+ N_{p2}), 0\}$.

If $N_{data}>N_{sys}+N_{p1}+N_{p2}$, the second rate matching sub-module implements repetition operation. The number of transmitted system bits after bit repetition is $N_{t,sys} = \left\lfloor N_{sys} \cdot \dfrac{N_{data}}{N_{sys} + 2N_{p1}} \right\rfloor$, and the numbers of transmitted bits of the two check bit sequences are $N_{t,p1} = \left\lfloor \dfrac{N_{data} - N_{t,sys}}{2} \right\rfloor$ and $N_{t,p2} = \left\lceil \dfrac{N_{data} - N_{t,sys}}{2} \right\rceil$ respectively.

In the case of punching mode, i.e. $N_{data}<N_{sys}+N_{p1}+N_{p2}$, the rate matching parameter $e_{ini}$ of each bit sequence is determined by the RV parameters of r and s.

$$e_{ini}(r) = \left\{\left(X_i - \left\lfloor r \cdot e_{plus} / r_{max} \right\rfloor - 1\right) \bmod e_{plus}\right\}+1$$

In the case of the repetition mode, i.e. $N_{data}>N_{sys}+N_{p1}+N_{p2}$, the rate matching parameter $e_{ini}$ of each bit sequence is:

$$e_{ini}(r) = \left\{\left(X_i - \left\lfloor (s + 2 \cdot r) \cdot e_{plus} /(2 \cdot r_{max}) \right\rfloor - 1\right) \bmod e_{plus}\right\}+1$$

Where $r \in \{0,1,..r_{max}-1\}$, $r_{max}$ is the total number of redundancy obtained by changing r. It should be noted that the value of $r_{max}$ is determined by the modulation method. 16QAM $r_{max} = 2$; QPSK $r_{max} = 4$.

HARQ bit combination: the HARQ bit combination is carried out by an $N_{row} \times N_{col}$ interleaver. In the case of 16QAM, $N_{row} = 4$, and in the case of QPSK, $N_{row} = 2$. $N_{col} = N_{data} / N_{row}$. The data is written in and read out by column. $N_{t,sys}$ is the number of transmitted system bit data. The intermediate parameters of $N_r$ and $N_c$ respectively are:

$$N_r = \left\lfloor \frac{N_{t,sys}}{N_{col}} \right\rfloor \quad \text{and} \quad N_c = N_{t,sys} - N_r \cdot N_{col}$$

If $N_c=0$, the system bits are written in rows $1...N_r$. Otherwise, the system bits are written in rows $1...N_{r+1}$ of the first $N_c$ columns; if $N_r>0$, the system bits are also written in rows $1...N_r$ of the remaining $N_{col}-N_c$ columns, and first check bits and second check bits are written alternately in rows of the remaining space by column. The first bit written in the column is the bit with the minimum subscript among second parity check bits.

In the case of 16QAM mode, the order of bits read out from each column is arranged as follows: the 1st row, the 2nd row, the 3rd row and the 4th row. In the case of QPSK mode, the order of bits read out from each column is arranged as follows: the 1st row and the 2nd row.

Physical channel segmentation of the HS-DSCH:

If the number of used HS-PDSCH channels is P (P>1), the physical channel segmentation module distributes bits for multiple physical channels. The bits input to the physical channel distribution unit are represented as $w_1$, $w_2$, $w_3$, ..., $w_R$, and the subscript R represents the number of bits input to the physical channel segmentation module. The sequence output from the physical channel segmentation module is $u_{p1}$, $u_{p2}$, $u_{p3}$, ..., $u_{pU}$, where, p is the sequence number of the physical channel, and u is the number of bits in the HS-PDSCH sub-frame, i.e. u=R/p. The relationship between $w_k$ and $u_{pk}$ is:

Whatever the mode is, the number of bits that are filled in each frame is required to reach to u. The bits of the first physical channel after physical channel distribution are:

$$u_{1,k}=w_k \qquad k=1,2,\ldots,U$$

The bits of the second physical channel after physical channel distribution are:

$$u_{2,k}=w_{k+U} \qquad k=1,2,\ldots,U$$

The bits of the Pth physical channel after physical channel distribution are:

$$u_{P,k}=w_{k+(P-1)\times U} \qquad k=1,2,\ldots,U$$

HS-DSCH interleaving:

Figure 3 shows the HS-DSCH interleaver with independent interleaving process in each physical channel. The bit sequence input into the block interleaver is $u_{p,1}, u_{p,2}, u_{p,3}, \ldots, u_{p,U}$; for QPSK modulation, U=960, and for 16QAM modulation, U=1920. The interleaver for the QPSK modulation is the same as the second interleaver of the other physical channel, the size of which is R2×C2=32×30.

In the case of 16QAM modulation, two interleavers with same size (R2×C2=32 ×30) are used, and the bit sequence output from the physical channel segmentation module is divided into two sequences, where $u_{p,k}$ and $u_{p,k+1}$ are transmitted to Interleaver 1, and $u_{p,k+2}$ and $u_{p,k+3}$ are transmitted to Interleaver 2.

16QAM constellation rearrangement:

For 16QAM modulation, bit sequence needs to be processed by a 16QAM constellation rearranging module, while in the QPSK modulation, the bit sequence does not need the processing of this module.

Some wireless technologies supporting high spectral efficiency such as MIMO (Multiple-input Multiple-output) and high-order modulation (64QAM or higher) should be used for improving spectral efficiency and peak rate in 5MHz bandwidth.

However, the effect of 64QAM is not considered for the existing HS-DSCH coding and multiplexing solution. The existing solution can not satisfy the demands of 64QAM, and 64QAM cannot be directly used on the basis of the existing solution.

"3GPP TR 25.858 V5.0.0; Technical Specification Group Radio Access Network; High Speed Downlink Packet Access; Physical Layer Aspects (Release 5)" 3[RD] GENERATION PARTNERSHIP PROJECT, XP002549338 discloses a solution of HARQ bit collection.

Summary of the Invention

An embodiment of the present invention provides a method and system for coding and multiplexing in high speed downlink shared channel, through which 64QAM can be used based on the technology of coding and multiplexing in high speed downlink shared channel, thereby the transmission performance of the high speed downlink shared channel is improved.

An embodiment of the present invention provides a method for coding and multiplexing in high speed downlink shared channel, including writing by column in turn, data to be combined in a memory space that is arranged as 6 rows and reading out by column, the data from the memory space, wherein the data of each column are read out in one of the following orders: the 1st row, the 3rd row the 5th row, the 2nd row the 4th row and the 6th row; or the 1st row, the 4th row, the 2nd row, the 5th row, the 3rd row and the 6th row; or the 1 st row, the 5th row, the 2nd row, the 6th row, the 3rd row and the 4th row; or writing by column at first, data to be combined in a memory space that is arranged as 6 rows; and reading out by row, the data from the memory space; or writing by row at first, data to be combined in a memory space that is arranged as 6 rows and reading out by column, the data from the memory space; when implementing 64 Quadrature Amplitude Modulation (QAM) Hybrid Automatic Repeat Request (HARQ) bit combination.

An embodiment of the present invention further provides a method for coding and multiplexing in high speed downlink shared channel, including carrying out each HARQ transmission according to the following parameters if 64QAM mode is used and $r_{max} = 1$, when implementing a second rate matching.

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |

(continued)

| Redundancy Version No. | s | r | b |
| --- | --- | --- | --- |
| 4 | 1 | 0 | 1 |
| 5 | 1 | 0 | 2 |
| 6 | 1 | 0 | 3 |
| 7 | 1 | 1 | 0 |

Where, s and r are parameters adapted to control the second rate matching algorithm, and b is a parameter of constellation version in the case of 64QAM.

An embodiment of the present invention further provides a method for coding and multiplexing in high speed downlink shared channel, including carrying out each HARQ transmission according to the following parameters if 64QAM mode is used and $r_{max} = 2$, when implementing the second rate matching.

| Redundancy Version No. | s | r | b |
| --- | --- | --- | --- |
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

Where, s and r are parameters adapted to control the second rate matching algorithm, and b is a parameter of constellation version in the case of 64QAM.

An embodiment of the present invention further provides a method for coding and multiplexing in high speed downlink shared channel, including carrying out each HARQ transmission according to the following parameters if 64QAM mode is used and $r_{max} = 4$, when implementing the second rate matching.

| Redundancy Version No. | s | r | b |
| --- | --- | --- | --- |
| 0 | 1 | 0 | 0 |
| 1 | 0 | 0 | 0 |
| 2 | 1 | 1 | 1 |
| 3 | 0 | 1 | 1 |
| 4 | 1 | 2 | 1 |
| 5 | 0 | 2 | 2 |
| 6 | 1 | 3 | 3 |
| 7 | 0 | 3 | 0 |

Where, s and r are parameters adapted to control the second rate matching algorithm, and b is a parameter of constellation version in the case of 64QAM.

An embodiment of the present invention further provides a method for coding and multiplexing in high speed downlink shared channel, including: in the case of 64QAM, when interleaving after the segmentation of physical channel, dividing the bit sequence obtained from the segmentation of physical channel into at least two sequences, which are interleaved through interleavers with the same size respectively.

An embodiment of the present invention further provides a method for coding and multiplexing in high speed downlink shared channel, including implementing constellation rearrangement for input bits $v_{p,k}$, $v_{p,k+1}$, $v_{p,k+2}$, $v_{p,k+3}$, $v_{p,k+4}$, $v_{p,k+5}$ in one of the following manners, when implementing the constellation rearrangement:

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+3}v_{p,k+4}v_{p,k+5}v_{p,k}v_{p,k+1}v_{p,k+2}$ |
| 2 | $v_{p,k}\ v_{p,k+1}v_{p,k+2}v_{p,k+3}\overline{v_{p,k+4}v_{p,k+5}}$ |
| 3 | $v_{p,k+3}v_{p,k+4}v_{p,k+5}v_{p,k}\overline{v_{p,k+1}v_{p,k+2}}$ |

Or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+4}\ v_{p,k+5}v_{p,k+2}v_{p,k+3}\ v_{p,k}v_{p,k+1}$ |
| 2 | $v_{p,k}\ v_{p,k+1}v_{p,k+2}v_{p,k+3}\overline{v_{p,k+4}v_{p,k+5}}$ |
| 3 | $v_{p,k+4}v_{p,k+5}v_{p,k+2}v_{p,k+3}\overline{v_{p,k}v_{p,k+1}}$ |

Or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+2}v_{p,k+3}v_{p,k+4}v_{p,k+5}v_{p,k}v_{p,k+1}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{p,k+3}v_{p,k+4}v_{p,k+5}\overline{v_{p,k}v_{p,k+1}}$ |

Or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+2}v_{p,k+3}v_{p,k}v_{p,k+1}v_{p,k+4}v_{p,k+5}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{k+1}v_{p,k}v_{p,k+1}\overline{v_{p,k+4}v_{p,k+5}}$ |

Or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k}v_{p,k+1}v_{p,k+4}v_{p,k+5}v_{p,k+2}v_{p,k+3}$ |
| 2 | $v_{p,k}v_{p,k+1}v_{p,k+2}v_{p,k+3}\ \overline{v_{p,k+4}v_{p,k+5}}$ |
| 3 | $v_{p,k}v_{p,k+1}v_{p,k+4}v_{p,k+5}\overline{v_{p,k+2}v_{p,k+3}}$ |

Or,

7

| Constellation version parameter b | Output bit sequence |
|---|---|
| 0 | $v_{p,k} v_{p,k+1} v_{p,k+2} v_{p,k+3} v_{p,k+4} v_{p,k+5}$ |
| 1 | $v_{p,k+4} v_{p,k+5} v_{p,k} v_{p,k+1} v_{p,k+2} v_{p,k+3}$ |
| 2 | $v_{p,k} v_{p,k+1} v_{p,k+2} v_{p,k+3} \overline{v_{p,k+4} v_{p,k+5}}$ |
| 3 | $v_{p,k+4} v_{p,k+5} v_{p,k} v_{p,k+1} \overline{v_{p,k+2} v_{p,k+3}}$ |

Where $\overline{v_{p,i}}$ represents the inversion of $v_{p,i}$.

An embodiment of the present invention provides a system for coding and multiplexing in high speed downlink shared channel, including a Hybrid Automatic Repeat Request (HARQ) bit combining module configured to write by column in turn, data to be combined in a memory space that is arranged as 6 rows and read out by column, the data from the memory space, wherein data of each column are read out in one of the following orders: a 1st row, a 3rd row, a 5th row, a 2nd row, a 4th row and a 6th row; or a 1st row, a 4th row, a 2nd row, a 5th row, a 3rd row and a 6th row; or a 1st row, a 5th row, a 2nd row, a 6th row, a 3rd row and a 4th row; or write by column at first, data to be combined in a memory space that is arranged as 6 rows; and read out by row, the data from the memory space; or write by column at first, data to be combined in a memory space that is arranged as 6 rows; and read out by row, the data from the memory space; or write by row at first, data to be combined in a memory space that is arranged as 6 rows and read out by column, the data from the memory space , when implementing 64 Quadrature Amplitude Modulation (QAM) HARQ bit combination.

An embodiment of the present invention further provides a system for coding and multiplexing in high speed downlink shared channel, including a second rate matching module adapted to carry out each HARQ transmission according to the following parameters if 64QAM mode is used and $r_{max} = 1$:

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

Where, s and r are parameters adapted to control the second rate matching algorithm, and b is a parameter of constellation version in the case of 64QAM.

An embodiment of the present invention further provides a system for coding and multiplexing in high speed downlink shared channel, including a second rate matching module adapted to carry out each HARQ transmission according to the following parameters if 64QAM mode is used and $r_{max} = 2$:

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

Where, s and r are parameters adapted to control the second rate matching algorithm, and b is a parameter of constellation version in the case of 64QAM.

An embodiment of the present invention further provides a system for coding and multiplexing in high speed downlink shared channel, including a second rate matching module adapted to carry out each HARQ transmission according to the following parameters if 64QAM mode is used and $r_{max} = 4$:

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 2 | 1 |
| 5 | 0 | 2 | 2 |
| 6 | 1 | 3 | 3 |
| 7 | 0 | 3 | 0 |

Where, s and r are parameters adapted to control the second rate matching algorithm, and b is a parameter of constellation version in the case of 64QAM.

An embodiment of the present invention further provides a system for coding and multiplexing in high speed downlink shared channel, including an interleaving module adapted to divide the bit sequence output from the physical channel segmentation module into at least two sequences, which are interleaved through interleavers with the same size respectively in the case of 64QAM.

It could be seen from the above technical solution that the embodiments of the present invention may satisfy the requirement for HARQ bit combination in the case of 64QAM modulation by writing the data to be combined in the memory space arranged as 6 rows and then reading out the data from the memory space, when implementing HARQ bit combination. Embodiments of the present invention have proposed various designs for parameters, through which better transmission effect may be obtained when the second rate matching is implemented. The interleaving in the case of 64QAM modulation may be implemented by dividing the bit sequence obtained from the segmentation of physical channel into at least two sequences which are then interfered through interleavers with the same size respectively in the case of 64QAM modulation. The embodiments of the present invention also provide several constellation rearrangement solutions in which the reliability of each bit is relatively balanced and the whole transmission quality is improved by using output bit sequences, in HARQ retransmission, that are different from the output bit sequences in the previous transmission or retransmission.

Brief Description of the Drawings

Figure 1 is a flow diagram illustrating a method for coding and multiplexing in HS-DSCH according to the prior art;

Figure 2 is a schematic diagram illustrating the structure of HARQ module of the HS-DSCH according to the prior art;

Figure 3 is a schematic diagram illustrating the structure of interleaver of the HS-DSCH according to the prior art;

Figure 4 is a diagram illustrating the simulation result according to an embodiment of the present invention;

Figure 5 is a schematic diagram illustrating the structure of a HS-PDSCH sub-frame;

Figure 6 is a schematic diagram illustrating the first HS-DSCH interleaving method according to an embodiment of the present invention; and

Figure 7 is a schematic diagram illustrating the second HS-DSCH interleaving method according to an embodiment of the present invention.

Detailed Description of the Embodiments

The present invention will be described in detail with reference to the accompanying drawings in order to make the object, technical solution and advantages of the embodiments of the present invention clearer.

The embodiments of the present invention are improved based on the HS-DSCH coding and multiplexing solution of the prior art. The 2m Transmission Timing Interval (TTI) of the High Speed Downlink Shared Channel (HS-DSCH) bears at most one data block, and each HS-DSCH data block for inputting coding and multiplexing chain is mapped into a 3-slot HS-DSCH sub-frame after being coded and multiplexed.

The HS-DSCH coding and multiplexing method includes the following steps: addition of Cyclic Redundancy Check (CRC) information in transport block, bit scrambling, coding block segmentation, channel coding, Hybrid ARQ, physical channel segmentation, interleaving, 64 Quadrature Amplitude Modulation (QAM) constellation rearrangement and physical channel mapping.

The HS-DSCH coding and multiplexing system includes the following modules: a CRC adding module, a bit scrambling module, a coding block segmentation module, a channel coding module, an HARQ function module, a physical channel segmentation module, an interleaving module, a constellation rearranging module and a physical channel mapping module.

In the embodiments of the present invention, the three steps of HARQ, interleaving and constellation rearrangement in the HS-DSCH coding and multiplexing method are improved.

In the embodiments of the present invention, the three modules of HARQ function module, interleaving module and constellation rearranging module in the HS-DSCH coding and multiplexing system are improved.

The improved modules and steps will be described below.

Referring to Figure 2, the HARQ includes several modules of a bit separation module, a first rate matching module, a virtual IR bluffer, a second rate matching module and a bit collection module. The second rate matching module is improved in this embodiment.

In the case of punching mode, i.e. $N_{data}<N_{sys}+N_{p1}+N_{p2}$, the rate matching parameter $e_{ini}$ of each bit sequence is determined by the RV parameters r and s.

$$e_{ini}(r) = \left\{ \left( X_i - \left\lfloor r \cdot e_{plus} / r_{max} \right\rfloor - 1 \right) \bmod e_{plus} \right\} + 1$$

In the case of repetition mode, i.e. $N_{data}>N_{sys}+N_{p1}+N_{p2}$, the rate matching parameter $e_{ini}$ of each bit sequence is:

$$e_{ini}(r) = \left\{ \left( X_i - \left\lfloor (s + 2 \cdot r) \cdot e_{plus} / (2 \cdot r_{max}) \right\rfloor - 1 \right) \bmod e_{plus} \right\} + 1$$

Where $r \in \{0,1,...r_{max}-1\}$, $r_{max}$ is the total number of redundancy obtained by changing r. It should be noted that the value of $r_{max}$ is determined by the modulation method. 64QAM $r_{max} = 1$, 16QAM $r_{max} = 2$; QPSK $r_{max} = 4$.

In the case of 64QAM mode, the Redundancy Version (RV) parameters s and r are designed as follows:

64QAM $r_{max} = 1$

| $X_{rv}$ (value) | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

64QAM $r_{max} = 2$

| $X_{rv}$ (value) | s | r | b |
|---|---|---|---|
| 0 | 1 | 0 | 0 |
| 1 | 0 | 0 | 0 |

(continued)

| $X_{rv}$ (value) | s | r | b |
|---|---|---|---|
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

64QAM $r_{max}$ = 4

| $X_{rv}$ (value) | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 2 | 1 |
| 5 | 0 | 2 | 2 |
| 6 | 1 | 3 | 3 |
| 7 | 0 | 3 | 0 |

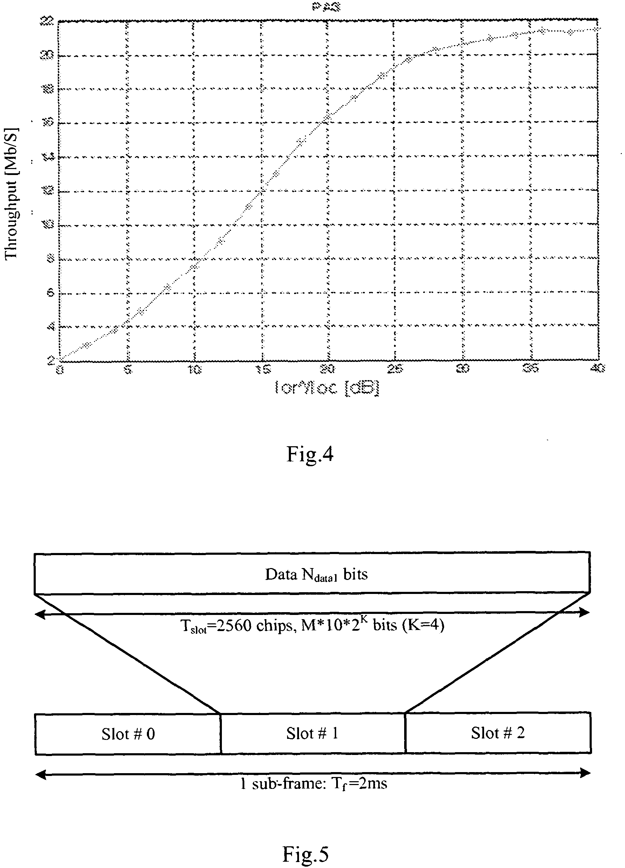

By simulations, it is proved that better system performance can be obtained by use of the above parameters. Figure 4 shows the simulation result in the case of PA channel when $R_{max}$ = 2 in the 64QAM mode. It could be seen from the simulation curve that the maximum throughput in this solution is 21.6Mbps, and the system throughput is greatly improved.

A first embodiment of the HARQ bit combination:

The HARQ bit collection is carried out by an $N_{row} \times N_{col}$ interleaver. In the case of 64QAM mode, $N_{row}$=6, $N_{col}$ = $N_{data}$ / $N_{row}$. The data is written in and read out by column. The method for writing in is the same as the first prior art. In the case of 64QAM mode, the order of bits read out from each column is arranged as follows: the 1st row, the 3rd row, the 5th row, the 2nd row, the 4th row and the 6th row; or as follows: the 1st row, the 4th row, the 2nd row, the 5th row, the 3rd row and the 6th row; or: the 1st row, the 5th row, the 2nd row, the 6th row, the 3rd row and the 4th row; or: the 1 st row to the 6th row.

Compared with the ordinal reading method in the prior art, the "jumping" reading method is able to obtain better interleaving effect and improve the performance of the HARQ.

A second embodiment of the HARQ bit collection:

The HARQ bit collection is carried out by an $N_{row} \times N_{col}$ interleaver. In the case of 64QAM mode, $N_{row}$=6, $N_{col}$ = $N_{data}$ / $N_{row}$. The data is written in by column and read out by row, i.e. system bits, first check bits and second check bits are alternately written in columns by column, and then read out by row in turn.

Compared with the method of writing by column and reading by column in the prior art, the method of writing by column and reading by row is able to obtain better interleaving effect and improve the performance of the HARQ.

A third embodiment of the HARQ bit collection:

The HARQ bit collection is carried out by an $N_{row} \times N_{col}$ interleaver. In the case of 64QAM mode, $N_{row}$=6, $N_{col}$ = $N_{data}$ / $N_{row}$. The data is written in by row and read out by column, i.e. system bits, first check bits and second check bits are alternately written in rows by column, and then read out by column in turn.

Compared with the method of writing by column and reading by column in the prior art, the method of writing by row and reading by column is able to obtain better interleaving effect and improve the performance of the HARQ.

A first embodiment of the interleaving:

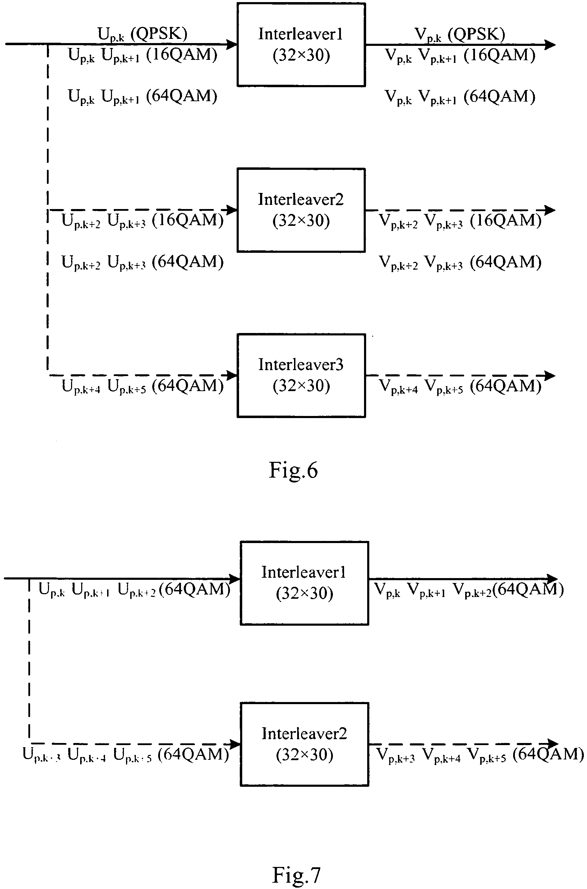

The sub-frame structure of the HS-PDSCH is shown in Figure 5, and the spread spectrum factor is 16. Therefore, in the case of 64QAM modulation, the number of bits beard in each time slot is 960, and the number of bits beard in one sub-frame is 2880. The bit sequence input to the interleaver is $u_{p,1}, u_{p,2}, u_{p,3} ... u_{p,U}$. In the case of 64QAM modulation, U is 2880. So when the 64QAM mode is used, the following interleaving solution is given: three interleavers with the same size R2×C2=32×30 are used, and the bit sequence output from the physical channel segmentation module is divided into three sequences, where $u_{p,k}$ and $u_{p,k+1}$ are transmitted to Interleaver 1, $u_{p,k+2}$ and $u_{p,k+3}$ are transmitted to Interleaver 2, $u_{p,k+4}$ and $u_{p,k+5}$ are transmitted to Interleaver 3, and the three sequences are interleaved by the R2×C2=32×30 interleaver respectively. As shown in Figure 6, the outputs of Interleaver 1 are $v_{p,k}$ and $v_{p,k+1}$, the outputs of Interleaver 2 are $v_{p,k+2}$ and $v_{p,k+2}$, and the outputs of Interleaver 3 are $v_{p,k+4}$ and $v_{p,k+5}$.

Since the bit sequence output from the physical channel segmentation module is divided into three sequences, the requirement of the 64QAM may be satisfied; and since the used interleaver has the same size as the interleaver used in the 16QAM mode, better compatibility with the existing system may be implemented.

A second embodiment of interleaving:

As shown in Figure 7, this embodiment is suitable for the 64QAM mode. In the case of 64QAM modulation, two interleavers with system size R2×C2= 48×30 are used, and the bit sequence output from the physical channel segmentation module is divided into two sequences, where $u_{p,k}$, $u_{p,k+1}$ and $u_{p,k+2}$ are transmitted to Interleaver 1, $u_{p,k+3}$, $u_{p,k+4}$ and $u_{p,k+5}$ are transmitted to Interleaver 2, and the two sequences are interleaved by the R2×C2=48×30 interleaver respectively. The outputs of Interleaver 1 are $v_{p,k}$, $v_{p,k+1}$ and $v_{p,k+2}$, and the outputs of Interleaver 2 are $v_{p,k+3}$, $v_{p,k+4}$ and $v_{p,k+5}$.

Constellation rearrangement is needed in the case of 64QAM modulation. The input bits are divided into 6 groups, and $v_{p,k}$, $v_{p,k+1}$, $v_{p,k+2}$, $v_{p,k+3}$, $v_{p,k+4}$, $v_{p,k+5}$ are mapped to $r_{p,k}$, $r_{p,k+1}$, $r_{p,k+2}$, $r_{p,k+3,1}$, $r_{p,k+4}$, $r_{p,k+5}$, where k mod 6 = 1.

A first embodiment of the constellation rearrangement:

$v_{p,k}$, $v_{p,k+1}$, $v_{p,k+2}$, $v_{p,k+3}$, $v_{p,k+4}$, , $v_{p,k+5}$ are divided into two groups: the first three most significant bits and the last three least significant bits. The first three most significant bits have higher reliability and the last three least significant bits have lower reliability. Neither the order nor the reliability of these bits is changed during the first transmission, while the reliability of these bits is changed or the bits are inversed during the retransmission, as shown in the following table, where $\overline{v_{p,i}}$ represents the inversion of $v_{p,i}$.

| Constellation version parameter b | Output bit sequence |
|---|---|
| 0 | $v_{p,k} v_{p,k+1} v_{p,k+2} v_{p,k+3} v_{p,k+4} v_{p,k+5}$ |
| 1 | $v_{p,k+3}\ v_{p,k+4} v_{p,k+5} v_{p,k} v_{p,k+1} v_{p,k+2}$ |
| 2 | $v_{p,k} v_{p,k+1} v_{p,k+2} \overline{v_{p,k+3} v_{p,k+4} v_{p,k+5}}$ |
| 3 | $v_{p,k+3} v_{p,k+4} v_{p,k+5} \overline{v_{p,k} v_{p,k+1} v_{p,k+2}}$ |

A second embodiment of the constellation rearrangement:

$v_{p,k}$, $v_{p,k+1}$, $v_{p,k+2}$, $v_{p,k+3}$, $v_{p,k+4}$, , $v_{p,k+5}$ are divided into three groups: the first two most significant bits, the middle two more significant bits and the last two least significant bits. The first two most significant bits have highest reliability, the middle two more significant bits have higher reliability and the last two least significant bits have lowest reliability. Neither the order nor the reliability of these bits is changed during the first transmission, while the reliability of these bits is changed or the bits arc inversed during the retransmission, as shown in the following table:

| Constellation version parameter b | Output bit sequence |
|---|---|
| 0 | $v_{p,k} v_{p,k+1} v_{p,k+2} v_{p,k+3} v_{p,k+4} v_{p,k+5}$ |
| 1 | $v_{p,k+4} v_{p,k+5} v_{p,k+2} v_{p,k+2} v_{p,k} v_{p,k+1}$ |
| 2 | $v_{p,k} v_{p,k+1} v_{p,k+2} \overline{v_{p,k+3} v_{p,k+4} v_{p,k+5}}$ |
| 3 | $v_{p,k+4} v_{p,k+5} v_{p,k+2} \overline{v_{p,k+3} v_{p,k} v_{p,k+1}}$ |

A third embodiment of the constellation rearrangement makes adjustment on the output bit sequence in the second embodiment as follows:

| Constellation version parameter b | Output bit sequence |
|---|---|
| 0 | $v_{p,k} v_{p,k+1} v_{p,k+2} v_{p,k+3} v_{p,k+4} v_{p,k+5}$ |
| 1 | $v_{p,k+2} v_{p,k+3}\ v_{p,k+4} v_{p,k+5} v_{p,k} v_{p,k+1}$ |

(continued)

| Constellation version parameter b | Output bit sequence |
|---|---|
| 2 | $v_{p,k}v_{p,k+1}v_{p,k+2}v_{p,k+3}\overline{v_{p,k+4}v_{p,k+5}}$ |
| 3 | $v_{p,k+2}v_{k+3}v_{p,k+4}v_{p,k+5}\overline{v_{p,k}v_{p,k+1}}$ |

A forth embodiment of the constellation rearrangement makes adjustment on the output bit sequence in the second embodiment as follows:

| Constellation version parameter b | Output bit sequence |
|---|---|
| 0 | $v_{p,k}v_{p,k+1}v_{p,k+3}v_{p,k+3}v_{p,k+4}v_{p,k+5}$ |
| 1 | $v_{p,k+2}v_{p,k+3}v_{p,k}v_{p,k+1}v_{p,k+4}v_{p,k+5}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{k+3}v_{p,k}v_{p,k+1}\overline{v_{p,k+4}v_{p,k+5}}$ |

A fifth embodiment of the constellation rearrangement makes adjustment on the output bit sequence in the second embodiment as follows:

| Constellation version parameter b | Output bit sequence |
|---|---|
| 0 | $v_{p,k}v_{p,k+1}v_{p,k+2}v_{p,k+2}v_{p,k+4}v_{p,k+5}$ |
| 1 | $v_{p,k}v_{p,k+1}v_{p,k+4}v_{p,k+4}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k}v_{p,k+1}v_{p,k+4}v_{p,k+5}\overline{v_{p,k+2}v_{k+3}}$ |

A sixth embodiment of the constellation rearrangement makes adjustment on the output bit sequence in the second embodiment as follows:

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k}v_{p,k+1}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k+4}v_{p,k+5}v_{p,k}v_{p,k+1}\overline{v_{p,k+2}v_{k+3}}$ |

It could be seen from the various embodiments of the constellation rearrangement that in the case of 64QAM, since the reliabilities of the six bits are different, the reliability of each bit is relatively balanced and the whole transmission quality is improved by using output bit sequences, in HARQ retransmission, that are different from the output bit sequences in the previous transmission or retransmission.

It should be explained that the improvements on the HARQ, interleaving and constellation rearrangement may be either used separately or combined together for better effect.

While the present invention has been illustrated and described with reference to some preferred embodiments of the present invention, but those skilled in the art should recognize that various variations and modifications can be made without departing from the scope of the present invention as defined by the accompanying claims.

**Claims**

1.   A method for coding and multiplexing in high speed downlink shared channel, **characterized by** comprising:

when implementing 64 Quadrature Amplitude Modulation (QAM) Hybrid Automatic Repeat Request (HARQ) bit combination;

writing by column in turn, data to be combined in a memory space that is arranged as 6 rows; and reading out by column, the data from the memory space, wherein data of each column are read out in one of the following orders: a 1st row, a 3rd row, a 5th row, a 2nd row, a 4th row and a 6th row; or a 1st row, a 4th row, a 2nd row, a 5th row, a 3rd row and a 6th row; or a 1st row, a 5th row, a 2nd row, a 6th row, a 3rd row and a 4th row; or writing by column at first, data to be combined in a memory space that is arranged as 6 rows; and reading out by row, the data from the memory space; or

writing by row at first, data to be combined in a memory space that is arranged as 6 rows; and reading out by column, the data from the memory space.

2. The method for coding and multiplexing in high speed downlink shared channel according to claim 1, **characterized by** further comprising:

carrying out each HARQ transmission according to the following parameters if 64QAM mode is used and $r_{max}$ = 1, when implementing a second rate matching:

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

wherein s and r are parameters configured to control the second rate matching algorithm, and b is a parameter of constellation version in the case of 64QAM.

3. The method for coding and multiplexing in high speed downlink shared channel according to claim 1, **characterized by** further comprising:

carrying out each HARQ transmission according to the following parameters if 64QAM mode is used and $r_{max}$ = 2, when implementing a second rate matching:

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

wherein s and r are parameters configured to control the second rate matching algorithm, and b is a parameter of constellation version in the case of 64QAM.

4. The method for coding and multiplexing in high speed downlink shared channel according to claim 1, **characterized**

**by** further comprising:

carrying out each HARQ transmission according to the following parameters if 64QAM mode is used and $r_{max}$ = 4, when implementing a second rate matching:

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 2 | 1 |
| 5 | 0 | 2 | 2 |
| 6 | 1 | 3 | 3 |
| 7 | 0 | 3 | 0 |

wherein s and r are parameters configured to control the second rate matching algorithm, and b is a parameter of constellation version in the case of 64QAM.

5. The method for coding and multiplexing in high speed downlink shared channel according to claim 1, **characterized by** further comprising:

in the case of 64QAM modulation, when interleaving after a segmentation of physical channel, dividing a bit sequence obtained from the segmentation of the physical channel into at least two sequences, which are interleaved through interleavers with a same size respectively.

6. The method for coding and multiplexing in high speed downlink shared channel according to claim 1, **characterized by** further comprising:

implementing constellation rearrangement for input bits $v_{p,k}$, $v_{p,k+1}$, $v_{p,k+2}$, $v_{p,k+3}$, $v_{p,k+4}$, $v_{p,k+5}$ in one of the following manners, when implementing the constellation rearrangement:

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+3}v_{p,k+4}v_{p,k+5}v_{p,k}v_{p,k+1}v_{p,k+2}$ |
| 2 | $v_{p,k}v_{p,k+1}v_{p,k+2}\overline{v_{p,k+3}v_{p,k+4}v_{p,k+5}}$ |
| 3 | $v_{p,k+3}v_{p,k+4}v_{p,k+5}\overline{v_{p,k}v_{p,k+1}v_{p,k+2}}$ |

or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k+2}v_{p,k+3}v_{p,k}v_{p,k+1}$ |
| 2 | $v_{p,k}v_{p,k+1}v_{p,k+2}v_{p,k+3}\overline{v_{p,k+4}v_{p,k+5}}$ |
| 3 | $v_{p,k+4}v_{p,k+5}v_{p,k+2}v_{k+3}\overline{v_{p,k}v_{p,k+1}}$ |

or,

| Constellation version parameter b | Output bit sequence |
| --- | --- |
| 0 | $v_{p,k}v_{p,k+1}v_{p,k+2}v_{p,k+3}v_{p,k+4}v_{p,k+5}$ |
| 1 | $v_{p,k+2}v_{p,k+3}v_{p,k+4}v_{p,k+5}v_{p,k}v_{p,k+1}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{k+3}v_{p,k+4}v_{p,k+5}\overline{v_{p,k}v_{p,k+1}}$ |

or,

| Constellation version parameter b | Output bit sequence |
| --- | --- |
| 0 | $v_{p,k}v_{p,k+1}v_{p,k+2}v_{p,k+3}v_{p,k+4}v_{p,k+5}$ |
| 1 | $v_{p,k+2}v_{p,k+3}v_{p,k}v_{p,k+1}v_{p,k+4}v_{p,k+5}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{k+3}v_{p,k}v_{p,k+1}\overline{v_{p,k+4}v_{p,k+5}}$ |

or,

| Constellation version parameter b | Output bit sequence |
| --- | --- |
| 0 | $v_{p,k}v_{p,k+1}v_{p,k+2}v_{p,k+3}v_{p,k+4}v_{p,k+5}$ |
| 1 | $v_{p,k}v_{p,k+1}v_{p,k+4}v_{p,k+5}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k}v_{p,k+1}v_{p,k+4}v_{p,k+5}\overline{v_{p,k+2}v_{k+3}}$ |

or,

| Constellation version parameter b | Output bit sequence |
| --- | --- |
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k}v_{p,k+1}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k+4}v_{p,k+5}v_{p,k}v_{p,k+1}\overline{v_{p,k+2}v_{k+3}}$ |

wherein $\overline{v_{p,i}}$ represents the inversion of $v_{p,i}$.

7. A system for coding and multiplexing in high speed downlink shared channel, **characterized by** comprising:

a Hybrid Automatic Repeat Request (HARQ) bit combining module configured to write by column in turn, data to be combined in a memory space that is arranged as 6 rows; and read out by column, the data from the memory space, wherein data of each column are read out in one of the following orders: a 1st row, a 3rd row, a 5th row, a 2nd row, a 4th row and a 6th row; or a 1st row, a 4th row, a 2nd row, a 5th row, a 3rd row and a 6th row; or a 1st row, a 5th row, a 2nd row, a 6th row, a 3rd row and a 4th row; or write by column at first, data to be combined in a memory space that is arranged as 6 rows; and read out by row, the data from the memory space; or write by row at first, data to be combined in a memory space that is arranged as 6 rows; and read out by column, the data from the memory space; when implementing 64 Quadrature Amplitude Modulation (QAM) HARQ bit combination.

8. The system for coding and multiplexing in high speed downlink shared channel according to claim 7, **characterized by** further comprising:

a second rate matching module configured to carry out each HARQ transmission according to the following parameters if 64QAM mode is used and $r_{max} = 1$:

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

wherein s and r are parameters configured to control the second rate matching algorithm, and b is a parameter of constellation version in the case of 64QAM.

9. The system for coding and multiplexing in high speed downlink shared channel according to claim 7, **characterized by** further comprising:

a second rate matching module configured to carry out each HARQ transmission according to the following parameters if 64QAM mode is used and $r_{max} = 2$:

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

wherein s and r are parameters configured to control the second rate matching algorithm, and b is a parameter of constellation version in the case of 64QAM.

10. The system for coding and multiplexing in high speed downlink shared channel according to claim 7, **characterized by** further comprising:

a second rate matching module configured to carry out each HARQ transmission according to the following parameters if 64QAM mode is used and $r_{max} = 4$:

| Redundancy Version No. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |

17

(continued)

| Redundancy Version No. | s | r | b |
|---|---|---|---|
| 4 | 1 | 2 | 1 |
| 5 | 0 | 2 | 2 |
| 6 | 1 | 3 | 3 |
| 7 | 0 | 3 | 0 |

wherein s and r are parameters configured to control the second rate matching algorithm, and b is a parameter of constellation version in the case of 64QAM.

11. The system for coding and multiplexing in high speed downlink shared channel according to claim 7, **characterized by** further comprising a physical channel segmentation module and an interleaving module,
wherein the interleaving module is configured to divide a bit sequence output from the physical channel segmentation module into at least two sequences, which are interleaved through interleavers with a same size respectively in the case of 64QAM.

12. The system for coding and multiplexing in high speed downlink shared channel according to claim 7, **characterized by** further comprising:

a constellation rearranging module configured to implement constellation rearrangement for input bits $v_{p,k}$, $v_{p,k+1}$, $v_{p,k+2}$, $v_{p,k+3}$, $v_{p,k+4}$, $v_{p,k+5}$ in one of the following manners:

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+3}v_{p,k+4}v_{p,k+5}v_{p,k}v_{p,k+1}v_{p,k+2}$ |
| 2 | $v_{p,k}v_{p,k+1}v_{p,k+2}\overline{v_{p,k+3}v_{p,k+4}v_{p,k+5}}$ |
| 3 | $v_{p,k+3}v_{p,k+4}v_{p,k+5}\overline{v_{p,k}v_{p,k+1}v_{p,k+2}}$ |

or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k+2}v_{p,k+3}v_{p,k}v_{p,k+1}$ |
| 2 | $v_{p,k}v_{p,k+1}v_{p,k+2}v_{p,k+3}\ \overline{v_{p,k+4}v_{p,k+5}}$ |
| 3 | $v_{p,k+4}v_{p,k+5}v_{p,k+2}v_{k+3}\ \overline{v_{p,k}v_{p,k+1}}$ |

or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+2}v_{p,k+3}v_{p,k+4}v_{p,k+5}v_{p,k}v_{p,k+1}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{k+3}v_{p,k+4}v_{p,k+5}\overline{v_{p,k}v_{p,k+1}}$ |

or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+2}v_{p,k+3}v_{p,k}v_{p,k+1}v_{p,k+4}v_{p,k+5}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{k+3}v_{p,k}v_{p,k+1}\overline{v_{p,k+4}v_{p,k+5}}$ |

or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k}v_{p,k+1}v_{p,k+4}v_{p,k+5}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k}v_{p,k+1}v_{p,k+4}v_{p,k+5}\overline{v_{p,k+2}v_{k+3}}$ |

or,

| Constellation version parameter b | Output bit sequence |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k}v_{p,k+1}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k+4}v_{p,k}+v_{p,k+5}v_{p,k}v_{p,k+1}\overline{v_{p,k+2}v_{k+3}}$ |

wherein $\overline{v_{p,i}}$ represents the inversion of $v_{p,i}$.

**Patentansprüche**

1.  Verfahren zum Kodieren und Multiplexen im gemeinsam benutzten schnellen Abwärtsstreckenkanal, **dadurch gekennzeichnet, dass** es Folgendes umfasst:

    beim Implementieren der Bitkombination der Hybrid Automatic Repeat Request bzw. HARQ der 64 Quadraturamplitudenmodulation bzw. QAM,
    der Reihe nach spaltenweises Schreiben von zu kombinierenden Daten in einem Speicherplatz, der als 6 Zeilen angeordnet ist; und spaltenweises Auslesen der Daten aus dem Speicherplatz, wobei Daten jeder Spalte in einer der folgenden Reihenfolgen ausgelesen werden: einer 1. Zeile, einer 3. Zeile, einer 5. Zeile, einer 2. Zeile, einer 4. Zeile und einer 6. Zeile; oder einer 1. Zeile, einer 4. Zeile, einer 2. Zeile, einer 5. Zeile, einer 3. Zeile und einer 6. Zeile; oder einer 1. Zeile, einer 5. Zeile, einer 2. Zeile, einer 6. Zeile, einer 3. Zeile und einer 4. Zeile; oder
    zuerst spaltenweises Schreiben von zu kombinierenden Daten in einem Speicherplatz, der als 6 Zeilen angeordnet ist; und zeilenweises Auslesen der Daten aus dem Speicherplatz; oder
    zuerst zeilenweises Schreiben von zu kombinierenden Daten in einem Speicherplatz, der als 6 Zeilen angeordnet ist; und spaltenweises Auslesen der Daten aus dem Speicherplatz.

2.  Verfahren zum Kodieren und Multiplexen im gemeinsam benutzten schnellen Abwärtsstreckenkanal nach Anspruch 1, **dadurch gekennzeichnet, dass** es ferner Folgendes umfasst:

    Ausführen jeder HARQ-Übertragung gemäß den folgenden Parametern, wenn 64 QAM-Modus verwendet wird und $r_{max}= 1$ ist, beim Implementieren einer Zweiratenanpassung:

| Redundanzversion Nr. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

wobei s und r Parameter sind, die dafür ausgelegt sind, den Zweitratenanpassungsalgorithmus zu steuern, und b ein Parameter der Konstellationsversion im Fall von 64 QAM ist.

3. Verfahren zum Kodieren und Multiplexen im gemeinsam benutzten schnellen Abwärtsstreckenkanal nach Anspruch 1, **dadurch gekennzeichnet, dass** es ferner Folgendes umfasst:

Ausführen jeder HARQ-Übertragung gemäß den folgenden Parametern, wenn 64 QAM-Modus verwendet wird und $r_{max}=2$ ist, beim Implementieren einer Zweitratenanpassung:

| Redundanzversion Nr. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

wobei s und r Parameter sind, die dafür ausgelegt sind, den Zweitratenanpassungsalgorithmus zu steuern, und b ein Parameter der Konstellationsversion im Fall von 64 QAM ist.

4. Verfahren zum Kodieren und Multiplexen im gemeinsam benutzten schnellen Abwärtsstreckenkanal nach Anspruch 1, **dadurch gekennzeichnet, dass** es ferner Folgendes umfasst:

Ausführen jeder HARQ-Übertragung gemäß den folgenden Parametern, wenn 64 QAM-Modus verwendet wird und $r_{max}=4$ ist, beim Implementieren einer Zweitratenanpassung:

| Redundanzversion Nr. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 2 | 1 |
| 5 | 0 | 2 | 2 |

(fortgesetzt)

| Redundanzversion Nr. | s | r | b |
|---|---|---|---|
| 6 | 1 | 3 | 3 |
| 7 | 0 | 3 | 0 |

wobei s und r Parameter sind, die dafür ausgelegt sind, den Zweitratenanpassungsalgorithmus zu steuern, und b ein Parameter der Konstellationsversion im Fall von 64 QAM ist.

5. Verfahren zum Kodieren und Multiplexen im gemeinsam benutzten schnellen Abwärtsstreckenkanal nach Anspruch 1, **dadurch gekennzeichnet, dass** es ferner Folgendes umfasst:

im Fall von 64 QAM-Modulation beim Verschachteln nach einer Segmentierung des physischen Kanals Aufteilen einer aus der Segmentierung des physischen Kanals erhaltenen Bitsequenz in mindestens zwei Sequenzen, die durch Verschachteler jeweils mit einer selben Größe verschachtelt werden.

6. Verfahren zum Kodieren und Multiplexen im gemeinsam benutzten schnellen Abwärtsstreckenkanal nach Anspruch 1, **dadurch gekennzeichnet, dass** es ferner Folgendes umfasst:

Implementieren von Konstellationsumordnung für die Eingangsbit $v_{p,k}$, $v_{p,k+1}$, $v_{p,k+2}$, $v_{p,k+3}$, $v_{p,k+4}$, $v_{p,k+5}$ auf eine der folgenden Weisen beim Implementieren der Konstellationsumordnung:

| Konstellationsversionsparameter b | Ausgangsbitsequenz |
|---|---|
| 0 | $v_{p,k}v_{p,k+1}v_{p,k+2}v_{p,k}v_{p,k+4}v_{p,k+5}$ |
| 1 | $v_{p,k+3}v_{p,k+4}v_{p,k+5}v_{p,k}v_{p,k+1}v_{p,k+2}$ |
| 2 | $\boldsymbol{v_{p,k}v_{p,k+1}v_{p,k+2}v_{p,k+3}\overline{v_{p,k+4}v_{p,k+5}}}$ |
| 3 | $\boldsymbol{v_{p,k+3}v_{p,k+4}v_{p,k+5}\overline{v_{p,k}v_{p,k+1}v_{p,k+2}}}$ |

oder

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k+2}v_{p,k+3}v_{p,k}v_{p,k+1}$ |
| 2 | $\boldsymbol{v_{p,k}v_{p,k+1}v_{p,k+2}v_{p,k+3}\overline{v_{p,k+4}v_{p,k+5}}}$ |
| 3 | $\boldsymbol{v_{p,k+4}v_{p,k+5}v_{p,k+2}v_{k+3}\overline{v_{p,k}v_{p,k+1}}}$ |

oder

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |
| 1 | $v_{p,k+2}v_{p,k+3}v_{p,k+4}v_{p,k+5}v_{p,k}v_{p,k+1}$ |
| 2 | $\boldsymbol{v_{p,k}v_{p,k+1}v_{p,k+2}v_{p,k+3}\ \overline{v_{p,k+4}v_{p,k+5}}}$ |
| 3 | $\boldsymbol{v_{p,k+2}v_{k+3}v_{p,k+4}\ v_{p,k+5}\ \overline{v_{p,k}v_{p,k+1}}}$ |

oder

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |

(fortgesetzt)

| Konstellationsversionsparameter b | Ausgangsbitsequenz |
|---|---|
| 1 | $v_{p,k+2}v_{p,k+3}v_{p,k}v_{p,k+1}\overline{v_{p,k+4}v_{p,k+5}}$ |
| 2 | $\mathbf{v_{p,k}v_{p,k+1}v_{p,k+2}v_{p,k+3}\overline{v_{p,k+4}v_{p,k+5}}}$ |
| 3 | $\mathbf{v_{p,k+2}v_{k+3}v_{p,k}v_{p,k+1}\overline{v_{p,k+4}v_{p,k+5}}}$ |

oder

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |
| 1 | $v_{p,k}v_{p,k+1}v_{p,k+4}v_{p,k+5}v_{p,k+2}v_{p,k+3}$ |
| 2 | $\mathbf{v_{p,k}v_{p,k+1}v_{p,k+2}v_{p,k+3}\overline{v_{p,k+4}v_{p,k+5}}}$ |
| 3 | $\mathbf{v_{p,k}v_{p,k+1}v_{p,k+4}v_{p,k+5}v_{p,k+2}v_{k+3}}$ |

oder

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k}v_{p,k+1}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k+4}v_{p,k+5}v_{p,k}v_{p,k+1}\overline{v_{p,k+2}}v_{k+3}$ |

wobei $\overline{v_{p,i}}$ die Inversion von $v_{p,i}$ repräsentiert.

**7.** System zum Kodieren und Multiplexen im gemeinsam benutzten schnellen Abwärtsstreckenkanal, **dadurch gekennzeichnet, dass** es Folgendes umfasst:

ein Bitkombiniermodul der Hybrid Automatic Repeat Request bzw. HARQ, das dafür ausgelegt ist, der Reihe nach spaltenweise zu kombinierende Daten in einem Speicherplatz, der als 6 Zeilen angeordnet ist, zu schreiben; und die Daten spaltenweise aus dem Speicherplatz auszulesen, wobei Daten jeder Spalte in einer der folgenden Reihenfolgen ausgelesen werden: einer 1. Zeile, einer 3. Zeile, einer 5. Zeile, einer 2. Zeile, einer 4. Zeile und einer 6. Zeile; oder einer 1. Zeile, einer 4. Zeile, einer 2. Zeile, einer 5. Zeile, einer 3. Zeile und einer 6. Zeile; oder einer 1. Zeile, einer 5. Zeile, einer 2. Zeile, einer 6. Zeile, einer 3. Zeile und einer 4. Zeile; oder zuerst spaltenweises Schreiben von zu kombinierenden Daten in einem Speicherplatz, der als 6 Zeilen angeordnet ist; und zeilenweises Auslesen der Daten aus dem Speicherplatz; oder zuerst zeilenweises Schreiben von zu kombinierenden Daten in einem Speicherplatz, der als 6 Zeilen angeordnet ist; und spaltenweises Auslesen der Daten aus dem Speicherplatz; beim Implementieren der HARQ-Bitkombination der 64-Quadraturamplitudenmodulation bzw. QAM.

**8.** System zum Kodieren und Multiplexen im gemeinsam benutzten schnellen Abwärtsstreckenkanal nach Anspruch 7, **dadurch gekennzeichnet, dass** es ferner Folgendes umfasst:

ein Zweitratenanpassungsmodul, das dafür ausgelegt ist, jede HARQ-Übertragung gemäß den folgenden Parametern auszuführen, wenn 64 QAM-Modus verwendet wird und $r_{max}=1$ ist:

| Redundanzversion Nr. | s | r | b |
|---|---|---|---|
| 0 | 1 | 0 | 0 |
| 1 | 0 | 0 | 0 |

(fortgesetzt)

| Redundanzversion Nr. | s | r | b |
|---|---|---|---|
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

wobei s und r Parameter sind, die dafür ausgelegt sind, den Zweitratenanpassungsalgorithmus zu steuern, und b ein Parameter der Konstellationsversion im Fall von 64 QAM ist.

9. System zum Kodieren und Multiplexen im gemeinsam benutzten schnellen Abwärtsstreckenkanal nach Anspruch 7, **dadurch gekennzeichnet, dass** es ferner Folgendes umfasst:

ein Zweitratenanpassungsmodul, das dafür ausgelegt ist, jede HARQ-Übertragung gemäß den folgenden Parametern auszuführen, wenn 64 QAM-Modus verwendet wird und $r_{max}=2$ ist:

| Redundanzversion Nr. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

wobei s und r Parameter sind, die dafür ausgelegt sind, den Zweitratenanpassungsalgorithmus zu steuern, und b ein Parameter der Konstellationsversion im Fall von 64 QAM ist.

10. System zum Kodieren und Multiplexen im gemeinsam benutzten schnellen Abwärtsstreckenkanal nach Anspruch 7, **dadurch gekennzeichnet, dass** es ferner Folgendes umfasst:

ein Zweitratenanpassungsmodul, das dafür ausgelegt ist, jede HARQ-Übertragung gemäß den folgenden Parametern auszuführen, wenn 64 QAM-Modus verwendet wird und $r_{max}=4$ ist:

| Redundanzversion Nr. | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 2 | 1 |
| 5 | 0 | 2 | 2 |
| 6 | 1 | 3 | 3 |

(fortgesetzt)

| Redundanzversion Nr. | s | r | b |
|---|---|---|---|
| 7 | 0 | 3 | 0 |

wobei s und r Parameter sind, die dafür ausgelegt sind, den Zweitratenanpassungsalgorithmus zu steuern, und b ein Parameter der Konstellationsversion im Fall von 64 QAM ist.

**11.** System zum Kodieren und Multiplexen im gemeinsam benutzten schnellen Abwärtsstreckenkanal nach Anspruch 7, **dadurch gekennzeichnet, dass** es ferner ein Segmentierungsmodul des physischen Kanals und ein Verschachtelungsmodul umfasst,

wobei das Verschachtelungsmodul dafür ausgelegt ist, eine von dem Segmentierungsmodul des physischen Kanals ausgegebene Bitsequenz in mindestens zwei Sequenzen aufzuteilen, die durch Verschachteler mit jeweils einer selben Größe im Fall von 64 QAM verschachtelt werden.

**12.** System zum Kodieren und Multiplexen im gemeinsam benutzten schnellen Abwärtsstreckenkanal nach Anspruch 7, **dadurch gekennzeichnet, dass** es ferner Folgendes umfasst:

ein Konstellationsumordnungsmodul, das dafür ausgelegt ist, Konstellationsumordnung für die Eingangsbit $v_{p,k}$, $v_{p,k+1}$, $v_{p,k+2}$, $v_{p,k+3}$, $v_{p,k+4}$, $v_{p,k+5}$ auf eine der folgenden Weisen zu implementieren:

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |
| 1 | $v_{p,k+3}v_{p,k+4}v_{p,k+5}v_{p,k}v_{p,k+1}v_{p,k+2}$ |
| 2 | $\mathbf{v_{p,k}v_{p,k+1}v_{p,k+2}\overline{v_{p,k+3}v_{p,k+4}v_{p,k+5}}}$ |
| 3 | $\mathbf{v_{p,k+3}v_{p,k+4}v_{p,k+5}\ \overline{v_{p,k}v_{p,k+1}v_{p,k+2}}}$ |

oder

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k+2}v_{p,k+3}v_{p,k}v_{p,k+1}$ |
| 2 | $\mathbf{v_{p,k}v_{p,k+1}v_{p,k+2}v_{p,k+3}\overline{v_{p,k+4}v_{p,k+5}}}$ |
| 3 | $\mathbf{v_{p,k+4}v_{p,k+5}v_{p,k+2}v_{k+3}\overline{v_{p,k}v_{p,k+1}}}$ |

oder

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |
| 1 | $v_{p,k+2}v_{p,k+3}v_{p,k+4}v_{p,k+4}v_{p,k+1}$ |
| 2 | $\mathbf{v_{p,k}v_{p,k+1}v_{p,k+2}v_{p,k+3}\ \overline{v_{p,k+4}v_{p,k+5}}}$ |
| 3 | $\mathbf{v_{p,k+2}v_{k+3}v_{p,k+4}\ v_{p,k+5}\ \overline{v_{p,k}v_{p,k+1}}}$ |

oder

| Konstellationsversionsparameter b | Ausgangsbitsequenz |
|---|---|
| 0 | $v_{p,k}v_{p,k+1}\ v_{p,k+2}v_{p,k+3}v_{p,k+4}v_{p,k+5}$ |
| 1 | $v_{p,k+2}v_{p,k+3}v_{p,k}v_{p,k+1}v_{p,k+4}v_{p,k+5}$ |

(fortgesetzt)

| Konstellationsversionsparameter b | Ausgangsbitsequenz |
|---|---|
| 2 | $v_{p,k}v_{p,k+1}\ v_{p,k+2}v_{p,k+3}\overline{v_{p,k+4}v_{p,k+5}}$ |
| 3 | $v_{p,k+2}v_{k+3}v_{p,k}v_{p,k+1}\overline{v_{p,k+4}\ v_{p,k+5}}$ |

oder

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |
| 1 | $v_{p,k}v_{p,k+1}\ v_{p,k+4}v_{p,k+5}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k}v_{p,k+1}v_{p,k+4}v_{p,k+5}\overline{v_{p,k+2}v_{k+3}}$ |

oder

| Konstellationsversionsparameter b | Ausgangsbitsequenz |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k}v_{p,k+1}v_{p,k+2}v_{p,k+3}$ |
| 2 | $v_{p,k}v_{p,k+1}v_{p,k+2}v_{p,k+3}\ \overline{v_{p,k+4}v_{p,k+5}}$ |
| 3 | $v_{p,k+4}v_{p,k+5}v_{p,k}v_{p,k+1}\ \overline{v_{p,k+2}v_{k+3}}$ |

wobei $\overline{v_{p,i}}$ die Inversion von $v_{p,i}$ repräsentiert.

## Revendications

1. Procédé de codage et multiplexage dans un canal partagé de liaison descendante à haut débit **caractérisé en ce qu'**il comprend :

   durant la mise en oeuvre d'une combinaison de bits HARQ (requête de répétition automatique hybride) à Modulation d'Amplitude en Quadrature (QAM) à 64 états ;
   l'écriture, une colonne à la fois, de données à combiner dans un espace de mémoire disposé en 6 rangées :
   et la lecture, par colonnes, des données de l'espace de mémoire, les données de chaque colonne étant lues dans l'un des ordres suivants : 1ère rangée, 3éme rangée, 5ème rangée, 2ème rangée, 4ème rangée et 6ème rangée ; ou 1ère rangée, 4ème rangée, 2ème rangée, 5ème rangée, 3ème rangée et 6ème rangée ; ou lire rangée, 5ème rangée, 2ème rangée, 6ème rangée, 3ème rangée et 4ème rangée ; ou
   l'écriture, en colonnes tout d'abord, de données à combiner dans un espace de mémoire disposé en 6 rangées ;
   et la lecture, en rangées, des données de l'espace de mémoire ; ou
   l'écriture, en rangées tout d'abord, de données à combiner dans un espace de mémoire disposé en 6 rangées ;
   et la lecture, en colonnes, des données de l'espace de mémoire.

2. Procédé de codage et multiplexage dans un canal partagé de liaison descendante à haut débit selon la revendication 1, **caractérisé en ce qu'**il comprend en outre :

   l'exécution de chaque transmission HARQ en fonction des paramètres suivants si le mode QAM à 64 états est utilisé et $r_{max} = 1$, durant la mise en oeuvre d'une adaptation de second débit :

   | Version de redondance n° | s | r | b |
   |---|---|---|---|
   | 0 | 1 | 0 | 0 |

(suite)

| Version de redondance n° | s | r | b |
|---|---|---|---|
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

où s et r sont des paramètres configurés pour commander l'algorithme d'adaptation de second débit, et b est un paramètre de version de constellation dans le cas de la QAM à 64 états.

**3.** Procédé de codage et multiplexage dans un canal partagé de liaison descendante à haut débit selon la revendication 1, **caractérisé en ce qu'**il comprend en outre :

l'exécution de chaque transmission HARQ en fonction des paramètres suivants si le mode QAM à 64 états est utilisé et $r_{max} = 2$, durant la mise en oeuvre d'une adaptation de second débit :

| Version de redondance n° | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

où s et r sont des paramètres configurés pour commander l'algorithme d'adaptation de second débit, et b est un paramètre de version de constellation dans le cas de la QAM à 64 états.

**4.** Procédé de codage et multiplexage dans un canal partagé de liaison descendante à haut débit selon la revendication 1, **caractérisé en ce qu'**il comprend en outre :

l'exécution de chaque transmission HARQ en fonction des paramètres suivants si le mode QAM à 64 états est utilisé et $r_{max} = 4$, durant la mise en oeuvre d'une adaptation de second débit :

| Version de redondance n° | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 2 | 1 |
| 5 | 0 | 2 | 2 |

(suite)

| Version de redondance n° | s | r | b |
|---|---|---|---|
| 6 | 1 | 3 | 3 |
| 7 | 0 | 3 | 0 |

où s et r sont des paramètres configurés pour commander l'algorithme d'adaptation de second débit, et b est un paramètre de version de constellation dans le cas de la QAM à 64 états.

5. Procédé de codage et multiplexage dans un canal partagé de liaison descendante à haut débit selon la revendication 1, **caractérisé en ce qu'**il comprend en outre :

dans le cas de la modulation QAM à 64 états, lors d'un entrelacement après une segmentation d'un canal physique, la division d'une séquence binaire obtenue à partir de la segmentation du canal physique en au moins deux séquences, lesquelles sont entrelacées par le biais d'entrelaceurs d'une même taille respectivement.

6. Procédé de codage et multiplexage dans un canal partagé de liaison descendante à haut débit selon la revendication 1, **caractérisé en ce qu'**il comprend en outre :

la mise en oeuvre d'un réagencement de constellation des bits d'entrée $v_{p,k}$, $v_{p,k+1}$, $v_{p,k+2}$, $v_{p,k+3}$, $v_{p,k+4}$, $v_{p,k+5}$ de l'une des façons suivantes, durant la mise en oeuvre d'un réagencement de constellation :

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+5}$ |
| 1 | $v_{p,k+3}v_{p,k+4}v_{p,k+3}v_{p,k}v_{p,k+1}v_{p,k+2}$ |
| 2 | $v_{p,k}v_{p,k+1}v_{p,k+2}\overline{v_{p,k+3}v_{p,k+4}v_{p,k+5}}$ |
| 3 | $v_{p,k+3}v_{p,k+4}v_{p,k+5}\overline{v_{p,k}v_{p,k+1}v_{p,k+2}}$ |

ou,

| Paramètre de version de constellation b | Séquence binaire de sortie |
|---|---|
| 0 | $v_{p,k}v_{p,k+1}v_{p,k+2}v_{p,k+3}v_{p,k+3}v_{p,k+5}$ |
| 1 | $v_{p,k+4}v_{p,k+5}v_{p,k+2}v_{p,k+3}v_{p,k}v_{p,k+1}$ |
| 2 | $v_{p,k}\ v_{p,k+1}v_{p,k+2}v_{p,k+3}\overline{v_{p,k+4}v_{p,k+5}}$ |
| 3 | $v_{p,k+4}v_{p,k+5}v_{p,k+2}v_{k+3}\overline{v_{p,k}v_{p,k+1}}$ |

ou,

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+4}v_{p,k+5}$ |
| 1 | $v_{p,k+2}v_{p,k+3}v_{p,k+4}v_{p,k+5}v_{p,k}v_{p,k+1}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{k+3}v_{p,k+4}v_{p,k+5}\overline{v_{p,k}v_{p,k+1}}$ |

ou,

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+5}$ |

(suite)

| Paramètre de version de constellation b | Séquence binaire de sortie |
|---|---|
| 1 | $v_{p,k+2}v_{p,k+3}v_{p,k}v_{p,k+1}v_{p,k+4}v_{p,k+5}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{k+3}v_{p,k}v_{p,k+1}\overline{v_{p,k+4}v_{p,k+5}}$ |

ou,

| Paramètre de version de constellation b | Séquence binaire de sortie |
|---|---|
| 0 | $v_{p,k}v_{p,k+1}v_{p,k+2}v_{p,k+2}v_{p,k+3}v_{p,k+4}v_{p,k+5}$ |
| 1 | $v_{p,k}v_{p,k+1}v_{p,k+4}v_{p,k+5}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k}v_{p,k+1}v_{p,k+4}v_{p,k+5}\overline{v_{p,k+2}v_{k+3}}$ |

ou,

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k}v_{p,k+1}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k+4}v_{p,k+5}v_{p,k}v_{p,k+1}\overline{v_{p,k+2}v_{k+3}}$ |

où $\overline{v_{p,i}}$ représente l'inversion de $v_{p,i}$.

7. Système de codage et multiplexage dans un canal partagé de liaison descendante à haut débit **caractérisé en ce qu'**il comprend :

un module de combinaison de bits HARQ (requête de répétition automatique hybride) configuré pour écrire, une colonne à la fois, des données à combiner dans un espace de mémoire disposé en 6 rangées ; et lire, en colonnes, les données de l'espace de mémoire, les données de chaque colonne étant lues dans l'un des ordres suivants :

1ère rangée, 3ème rangée, 5ème rangée, 2ème rangée, 4ème rangée et 6ème rangée ; ou 1ère rangée, 4ème rangée, 2ème rangée, 5ème rangée, 3ème rangée et 6ème rangée ; ou 1ère rangée, 5ème rangée, 2ème rangée, 6ème rangée, 3ème rangée et 4ème rangée ; ou
écrire, en colonnes tout d'abord, les données à combiner dans un espace de mémoire disposé en 6 rangées ; et lire, par rangées, les données de l'espace de mémoire ; ou
écrire, en rangées tout d'abord, les données à combiner dans un espace de mémoire disposé en 6 rangées ; et lire, en colonnes, les données de l'espace de mémoire ;
durant la mise en oeuvre d'une combinaison de bits HARQ à Modulation d'Amplitude en Quadrature (QAM) à 64 états.

8. Système de codage et multiplexage dans un canal partagé de liaison descendante à haut débit selon la revendication 7, **caractérisé en ce qu'**il comprend en outre :

un module d'adaptation de second débit configuré pour exécuter chaque transmission HARQ en fonction des paramètres suivants si le mode QAM à 64 états est utilisé et $r_{max} = 1$ :

| Version de redondance n° | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

où s et r sont des paramètres configurés pour commander l'algorithme d'adaptation de second débit, et b est un paramètre de version de constellation dans le cas de la QAM à 64 états.

**9.** Système de codage et multiplexage dans un canal partagé de liaison descendante à haut débit selon la revendication 7, **caractérisé en ce qu'**il comprend en outre :

un module d'adaptation de second débit configuré pour exécuter chaque transmission HARQ en fonction des paramètres suivants si le mode QAM à 64 états est utilisé et $r_{max}=2$:

| Version de redondance n° | S | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 1 |
| 5 | 1 | 0 | 2 |
| 6 | 1 | 0 | 3 |
| 7 | 1 | 1 | 0 |

où s et r sont des paramètres configurés pour commander l'algorithme d'adaptation de second débit, et b est un paramètre de version de constellation dans le cas de la QAM à 64 états.

**10.** Système de codage et multiplexage dans un canal partagé de liaison descendante à haut débit selon la revendication 7, **caractérisé en ce qu'**il comprend en outre :

un module d'adaptation de second débit configuré pour exécuter chaque transmission HARQ en fonction des paramètres suivants si le mode QAM à 64 états est utilisé et $r_{max} = 4$:

| Version de redondance n° | s | r | b |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 2 | 1 |
| 5 | 0 | 2 | 2 |

(suite)

| Version de redondance n° | s | r | b |
|---|---|---|---|
| 6 | 1 | 3 | 3 |
| 7 | 0 | 3 | 0 |

où s et r sont des paramètres configurés pour commander l'algorithme d'adaptation de second débit, et b est un paramètre de version de constellation dans le cas de la QAM à 64 états.

11. Système de codage et multiplexage dans un canal partagé de liaison descendante à haut débit selon la revendication 7, **caractérisé en ce qu'**il comprend en outre un module de segmentation de canal physique et un module d'entrelacement,
le module d'entrelacement étant configuré pour diviser une séquence binaire produite en sortie par le module de segmentation de canal physique en au moins deux séquences, lesquelles sont entrelacées par le biais d'entrelaceurs d'une même taille respectivement dans le cas de la QAM à 64 états.

12. Système de codage et multiplexage dans un canal partagé de liaison descendante à haut débit selon la revendication 7, **caractérisé en ce qu'**il comprend en outre :

un module de réagencement de constellation configuré pour mettre en oeuvre un réagencement de constellation de bits d'entrée $v_{p,k}$, $v_{p,k+1}$, $v_{p,k+2}$, $v_{p,k+3}$, $v_{p,k+4}$, $v_{p,k+5}$ de l'une des façons suivantes :

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+5}$ |
| 1 | $v_{p,k+3}v_{p,k+4}v_{p,k+5}v_{p,k}v_{p,k+1}v_{p,k+2}$ |
| 2 | $v_{p,k}v_{p,k+1}v_{p,k+2}\ v_{p,k+3}\overline{v_{p,k+4}v_{p,k+5}}$ |
| 3 | $v_{p,k+3}v_{p,k+4}v_{p,k+5}\overline{v_{p,k}v_{p,k+1}v_{p,k+2}}$ |

ou,

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k+2}v_{p,k+3}v_{p,k}v_{p,k+1}$ |
| 2 | $v_{p,k}v_{p,k+1}v_{p,k+2}v_{p,k+3}\ \overline{v_{p,k+4}v_{p,k+5}}$ |
| 3 | $v_{p,k+4}v_{p,k+5}v_{p,k+2}v_{k+3}\ \overline{v_{p,k}v_{p,k+1}}$ |

ou, n

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+5}$ |
| 1 | $v_{p,k+2}v_{p,k+3}v_{p,k+4}v_{p,k+5}\overline{v_{p,k}v_{p,k+1}}$ |
| 2 | $v_{p,k}\ v_{p,k+1}v_{p,k+2}v_{p,k+2}v_{p,k+3}\overline{v_{p,k+4}v_{p,k+5}}$ |
| 3 | $v_{p,k+2}v_{k+3}v_{p,k+4}\ v_{p,k+5}\overline{v_{p,k}v_{p,k+1}}$ |

ou,

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+5}$ |

(suite)

| Paramètre de version de constellation b | Séquence binaire de sortie |
|---|---|
| 1 | $v_{p,k+2}v_{p,k+3}v_{p,k}v_{p,k+1}v_{p,k+4}v_{p,k+5}$ |
| 2 | $v_{p,k}v_{p,k+1}v_{p,k+2}v_{p,k+3}\overline{v_{p,k+4}v_{p,k+5}}$ |
| 3 | $v_{p,k+2}v_{k+3}v_{p,k}v_{p,k+1}\overline{v_{p,k+4}v_{p,k+5}}$ |

ou,

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+5}$ |
| 1 | $v_{p,k}v_{p,k+1}v_{p,k+4}v_{p,k+5}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k}v_{p,k+1}v_{p,k+4}v_{p,k+5}\overline{v_{p,k+2}v_{k+3}}$ |

ou,

| Paramètre de version de constellation b | Séquence binaire de sortie |
|---|---|
| 0 | $v_{p,k}v_{p,k+1}v_{p,k+2}v_{p,k+3}v_{p,k+4}v_{p,k+5}$ |
| 1 | $v_{p,k+4}v_{p,k+5}v_{p,k}v_{p,k+1}v_{p,k+2}v_{p,k+3}$ |
| 2 | $v_{p,k}v_{p,k+1}v_{p,k+2}v_{p,k+3}\overline{v_{p,k+4}v_{p,k+5}}$ |
| 3 | $v_{p,k+4}v_{p,k+5}v_{p,k}v_{p,k+1}\overline{v_{p,k+2}v_{k+3}}$ |

où $\overline{v_{p,i}}$ représente l'inversion de $v_{p,i}$.

$a_{im1}, a_{im2}, a_{im3}, \ldots a_{imA}$     Addition of CRC check t

$b_{im1}, b_{im2}, b_{im3}, \ldots b_{imB}$     Bit scrambling

$d_{im1}, d_{im2}, d_{im3}, \ldots d_{imB}$     Coding block segmentation

$o_{ir1}, o_{ir2}, o_{ir3}, \ldots o_{irK}$     Channel coding

$c_{i1}, c_{i2}, c_{i3}, \ldots c_{iE}$     Physical layer HARQ function module

$w_1, w_2, w_3, \ldots w_R$     Physical channel segmentation

$u_{p,1}, u_{p,2}, u_{p,3}, \ldots u_{p,U}$     Interleaving

$v_{p,1}, v_{p,2}, v_{p,3}, \ldots v_{p,U}$     16QAM constellation rearrangement

$r_{p,1}, r_{p,2}, r_{p,3}, \ldots r_{p,U}$     Physical channel mapping

PhCH#1         PhCH#P

Fig.1

First rate matching    Virtual IR buffer    Second rate matching

Fig.2

Fig.3

Fig.4

Fig.5

$U_{p,k}$ (QPSK)
$U_{p,k}$ $U_{p,k+1}$ (16QAM)

$U_{p,k}$ $U_{p,k+1}$ (64QAM)

Interleaver1
(32×30)

$V_{p,k}$ (QPSK)
$V_{p,k}$ $V_{p,k+1}$ (16QAM)

$V_{p,k}$ $V_{p,k+1}$ (64QAM)

$U_{p,k+2}$ $U_{p,k+3}$ (16QAM)

$U_{p,k+2}$ $U_{p,k+3}$ (64QAM)

Interleaver2
(32×30)

$V_{p,k+2}$ $V_{p,k+3}$ (16QAM)

$V_{p,k+2}$ $V_{p,k+3}$ (64QAM)

$U_{p,k+4}$ $U_{p,k+5}$ (64QAM)

Interleaver3
(32×30)

$V_{p,k+4}$ $V_{p,k+5}$ (64QAM)

Fig.6

$U_{p,k}$ $U_{p,k+1}$ $U_{p,k+2}$(64QAM)

Interleaver1
(32×30)

$V_{p,k}$ $V_{p,k+1}$ $V_{p,k+2}$(64QAM)

$U_{p,k+3}$ $U_{p,k+4}$ $U_{p,k+5}$ (64QAM)

Interleaver2
(32×30)

$V_{p,k+3}$ $V_{p,k+4}$ $V_{p,k+5}$ (64QAM)

Fig.7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 200610143885

- CN 200710088882